# EUROPEAN PATENT APPLICATION

(11) **EP 1 041 617 A1**
(43) Date of publication of application: **04.10.2000**
(21) Application number: 99901117.4
(22) Date of filing: 20.01.1999
(51) Int. Cl.: H01L 21/60

(54) **SEMICONDUCTOR DEVICE AND METHOD OF PRODUCTION THEREOF AND SEMICONDUCTOR MOUNTING STRUCTURE AND METHOD**

(30) Priority: 20.01.1998 JP 839998
(71) Applicant: Citizen Watch Co., Ltd., Tokyo 163-0428 (JP)
(72) Inventor: TAGUCHI, Noboru Citizen Watch Co., Ltd., Tokorozawa-shi Saitama 359-8511 (JP); TOIDA, Takashi Citizen Watch Co., Ltd., Tokorozawa-shi Saitama 359-8511 (JP)
(74) Representative: Prüfer, Lutz H., Dipl.-Phys.
(86) International application number: JP9900183
(87) International publication number: WO9936958

(57) **Abstract**

A semiconductor device (1) comprises a semiconductor chip (12) provided with: a plurality of electrode pads (14); an insulating film (16) having an opening (16a) over the respective electrode pads (14) formed on the semiconductor chip (12); a plurality of lower electrodes (19) provided on the insulating film (16) in such a way to be electrically conductive with the respective electrode pads (14) through the respective openings (16a); and a plurality of bumps (22), each provided on the respective lower electrodes (19) so as to overhang from respective sidewall faces (12b, 12c) of the semiconductor chip (12). By mounting the semiconductor device (1) on a circuit board such that one of the sidewall faces of the semiconductor chip (12) is opposite the circuit board, and by connecting the plurality of the bumps (22) with electrodes on the circuit board, respectively, an area of junction therebetween is reduced, thereby enabling an electronic device to be downsized.

## Description

### TECHNICAL FIELD

The present invention relates to a surface-mounting semiconductor device provided with bumps (protruded electrodes), a method of fabricating the same, a structure for mounting the semiconductor device on a circuit board of a liquid crystal display device, and so forth, and a method of mounting the same.

### BACKGROUND TECHNOLOGY

Surface-mounting type semiconductor devices are in widespread use as a semiconductor device, consisting of an integrated circuit (IC), a large scale integrated circuit (LSI), and so forth.

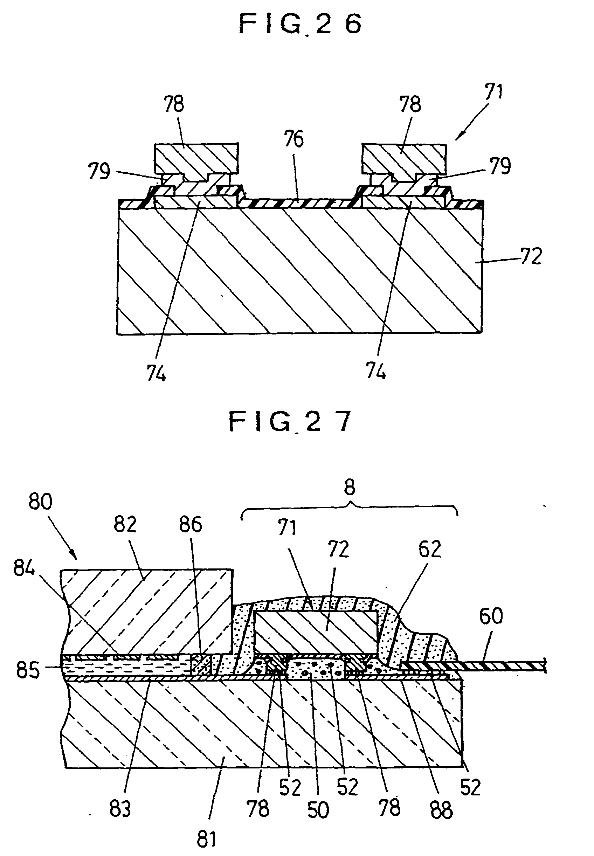

Among the surface-mounting type semiconductor devices, there is one provided with a multitude of bumps placed in lines on the surface thereof for electrical and mechanical connection with a wiring pattern on a circuit board when mounting the same on the circuit board. Fig. 26 shows the sectional construction of a semiconductor device provided with bumps formed in a straight-wall shape by way of example.

With the semiconductor device 71, a multitude of electrode pads 74 for connection with an external circuit are provided along side edges of a semiconductor chip 72, running in a direction orthogonal to the plane of the figure, on the surface (the upper face in the figure) of the semiconductor chip 72 with an integrated circuit (not shown) formed thereon. In Fig. 26, only one of a plurality of the electrode pads 74, disposed in respective lines along the side edge on both sides of the semiconductor chip 72, is shown.

An insulating film 76 having an opening formed over the respective electrode pads 74 in such a way as to cover a peripheral region of the respective electrode pads 74, and to expose the inside of the respective peripheral regions is provided on the entire upper surface of the semiconductor chip 72, and a lower electrode 79 is provided so as to be in intimate contact with the peripheral region of the respective openings of the insulating film 76 and an exposed part of the respective electrode pads 74. Further, on top of the respective lower electrodes 79, a bump 78 formed in a straight-wall shape is provided.

Thus, the semiconductor device 71 is provided with the bumps 78 formed in a straight-wall shape. In contrast, there is available another type of semiconductor device provided with bumps formed in a mushroom shape, wherein the top part of the bumps is larger than the base thereof. However, the semiconductor device provided with the bumps formed in a straight-wall shape is more suitable for reducing lateral spread thereof along the semiconductor chip 72, and to that extent, placement density of the bumps can be increased, so that a pitch at which connection with the external circuit is made can be miniaturized.

Such surface-mounting semiconductor devices provided with the bumps as described have since come to be used as, for example, driving semiconductor devices for a liquid crystal display device, and a plurality of such semiconductor devices for driving (for scanning and inputting signals) have come to be mounted on a peripheral region of a glass substrate making up a liquid crystal display panel of the liquid crystal display device.

Accordingly, a conventional structure for mounting a semiconductor device in a liquid crystal display device is described hereinafter with reference to Fig. 27 by way of example.

Reference numeral 80 denotes a liquid crystal display device wherein liquid crystal 85 is sealed in-between a first substrate 81 and a second substrate 82 by use of a sealing material 86, and a region 8 of the first substrate 81 where the first substrate 81 is extended beyond the edge of the second substrate 82 is a region where the semiconductor device 71 for driving the liquid crystal display device 80 is mounted. For the first and second substrate 81, 82, respectively, a glass substrates is generally used, however, a transparent resin substrate, and the like may be used as well.

A multitude of scanning electrodes 83 extending to the region 8 from the interior of the liquid crystal display panel with the liquid crystal 85 sealed therein, and a multitude of terminal electrodes 88 serving as connecting terminals to the external circuit are composed of a transparent and electrically conductive film, and are patterned on the upper surface of the first substrate 81 in such a way as to be placed in lines in the direction orthogonal to the plane of the figure. A multitude of signal electrodes 84 are composed of a transparent and electrically conductive film, and are patterned on the inner surface of the second substrate 82, opposite to the scanning electrodes 83 across the liquid crystal 85, in such a way as to be placed in lines in a transverse direction in the figure.

An anisotropic conductive adhesive 50 composed of electrically conductive particles 52 dispersed in an insulating adhesive is applied to the region 8 of the first substrate 81 of the liquid crystal display panel 80. Then, the semiconductor device 71 in a posture inverted from that shown in Fig. 26 is disposed in the region 8 of the first substrate 81 after alignment of the respective bumps 78 with the scanning electrodes 83 and the terminal electrodes 88 that are to be connected with the bumps 78, respectively.

In a condition where the semiconductor device 71 is set on the first substrate 81 with the anisotropic conductive adhesive 50 applied thereon as described above, pressure is applied to the semiconductor device 71 against the first substrate 81, and at the same time, heat treatment is applied thereto, thereby electrically connecting the respective bumps 78 with the scanning electrodes 83 and the terminal electrodes 88, respectively, via the electrically conductive particles 52 contained in the anisotropic conductive adhesive 50. Concurrently, the semiconductor device 71 is bonded to and securely mounted on the first substrate 81 by the insulating adhesive contained in the anisotropic conductive adhesive 50.

Further, one end of a flexible printed circuit board (FPC) 60 is disposed on a part of the upper surface of the first substrate 81 where the terminal electrodes 88 are formed. A wiring pattern (not shown), composed of a copper foil, for providing the semiconductor device 71 with a power supply source and input signals, is formed on the FPC 60.

By applying pressure and heat treatment between the FPC 60 and the terminal electrodes 88 as well, the wiring pattern on the FPC 60 is also electrically connected with the terminal electrodes 88 on the first substrate 81 via the electrically conductive particles 52 contained in the anisotropic conductive adhesive 50, and at the same time, the end of the FPC 60 is bonded to, and securely mounted on the first substrate 81.

By mounting the semiconductor device 71 in the manner as described above, the electrically conductive particles 52 contained in the anisotropic conductive adhesive 50 are securely held between the respective bumps 78 and the respective scanning electrodes 83 on the first substrate 81 as well as between the wiring pattern on the FPC 60 and the respective terminal electrodes 88 on the first substrate 81, thereby attaining electrical connection, respectively, and mechanical connection is also attained therebetween, respectively, by the insulating adhesive.

Thereafter, a mold resin 62 is applied to the upper surface as well as to the peripheral regions of junctions of the semiconductor device 71, and the FPC 60. This can prevent moisture from ingressing into junctions between the respective bumps 78 and the respective scanning electrodes 83 as well as junctions between the FPC 60 and the respective terminal electrodes 88 while providing these junctions with mechanical protection, so that reliability of the structure for mounting the semiconductor device can be enhanced.

However, a problem has been encountered with such a conventional structure of mounting the semiconductor device on a liquid crystal display device in that an area occupied by those junctions (the region 8 shown in Fig. 27) requires a fairly large size, thus interfering with the aim of downsizing the liquid crystal display device.

For example, the region 8 constituting a junction area for joining both the semiconductor device 71 and the FPC 60 with the liquid crystal display device 80 was found to be about 5 mm in width since it was necessary to take into account 2 mm as the width of the semiconductor device 71, 1 mm as connection allowance for the semiconductor device 71, and 2 mm as connection allowance for the FPC 60.

The region 8 of the liquid crystal display device 80, in which the semiconductor device is mounted, represents non-display sections of the liquid crystal display panel, so that a module size of the liquid crystal display panel has come to represent a fairly large proportion of the area of display section.

### DISCLOSURE OF THE INVENTION

The invention has been developed to solve the problem described above, and it is therefore an object of the invention to realize downsizing of a module of a liquid crystal display panel by reducing an area of a part of a liquid crystal display device and so forth for mounting a semiconductor device on a circuit board, further including an area for connecting a flexible printed circuit board to the semiconductor device, so that the invention can provide a semiconductor device suitable for high-density mounting, a method of fabricating the same efficiently, a structure for mounting the semiconductor device on a circuit board, and a method of mounting the same.

To this end, a semiconductor device according to the invention comprises: a semiconductor chip provided with an integrated circuit, and a plurality of electrode pads for connecting the integrated circuit to an external circuit; an insulating film having an opening over the respective electrode pads, formed on the semiconductor chip in such a way as to cover the peripheral region of the respective electrode pads; a plurality of lower electrodes provided on the insulating film in such a way as to be electrically conductive with the respective electrode pads through the respective openings of the insulating film; and a plurality of bumps provided on the respective lower electrodes in such a way as to overhang from respective sidewall faces of the semiconductor chip.

By providing the insulating film, the respective lower electrodes, and the respective bumps in such a way as to be extended from the surface of the semiconductor chip with the electrode pads provided thereon onto the respective sidewall faces, an area of the respective bumps, in a plane parallel to the respective sidewall faces of the semiconductor chip, is increased, thereby ensuring solid connection of the side face of the respective bumps with the circuit board.

The bumps may be formed of a single constituent material selected from the group consisting of copper, gold, nickel, and indium, or may be of a bi-layer structure composed of an underlying layer made of a metal selected from the group consisting of copper and nickel, and an upper layer made of gold. Otherwise, the bumps may be formed of a soldered alloy material.

A method of fabricating the semiconductor device according to the invention comprises:
a step of forming an insulating film provided with an opening over each of a plurality of electrode pads formed on a semiconductor substrate provided with integrated circuits for a plurality of semiconductor chips and the plurality of the electrode pads for connecting the integrated circuits with an external circuit;
a step of forming a common electrode film connected with the respective electrode pads through the respective openings on the entire upper surface of the semiconductor substrate with the insulating film formed thereon;
a step of forming a photosensitive resin film on the entire upper surface of the common electrode film, and patterning the photosensitive resin film such that an opening is formed in a region where bumps are to be formed, spreading over the semiconductor chips adjacent to each other;
a step of forming the bumps, spreading over the semiconductor chips adjacent to each other, on the common electrode film inside the opening of the photosensitive resin film;
a step of patterning the common electrode film using the bumps as an etching mask after removing the photosensitive resin film, thereby forming lower electrodes spreading over the semiconductor chips adjacent to each other;
a first dicing step of cuffing the bumps as well as the lower electrodes spreading over the semiconductor chips adjacent to each other, and the semiconductor substrate at the center between the semiconductor chips adjacent to each other from the side of the upper surface of the bumps; and
a second dicing step of performing dicing of the semiconductor substrate with a dicing width wider than that for the first dicing step from the side of the rear surface of the semiconductor substrate such that the center of the dicing coincides with that for the first dicing step.

Another method of fabricating the semiconductor device according to the invention comprises:
a step of forming a groove in a predetermined width and depth in the central region between semiconductor chips, adjacent to each other, of a semiconductor substrate provided with integrated circuits for a plurality of semiconductor chips and a plurality of electrode pads for connecting the integrated circuits with an external circuit, from the side of the upper surface of the semiconductor substrate provided with the electrode pads formed thereon;
a step of forming an insulating film on the entire upper surface of the semiconductor substrate and on the entire inner surface of the groove, and providing an opening in a region of the insulating film over the respective electrode pads;
a step of forming a common electrode film connected with the respective electrode pads through the respective openings on the entire upper surface of the semiconductor substrate with the insulating film formed thereon, including the inner surface of the groove;
a step of forming a photosensitive resin film on the entire upper surface of the common electrode film, and patterning the photosensitive resin film such that an opening is formed in a region where bumps are to be formed, spreading over the semiconductor chips adjacent to each other;
a step of forming the bumps spreading over the semiconductor chips adjacent to each other on the common electrode film inside the opening of the photosensitive resin film, including the inner surface of the groove;
a step of patterning the common electrode film using the bumps as an etching mask after removing the photosensitive resin film, thereby forming lower electrodes spreading over the semiconductor chips adjacent to each other;
a first dicing step of cutting the bumps as well as the lower electrodes spreading over the semiconductor chips adjacent to each other, and the semiconductor substrate at the center of the groove from the side of the upper surface of the bumps; and
a second dicing step of performing dicing of the semiconductor substrate with a dicing width corresponding to the width of the groove, from the side of the rear surface of the semiconductor substrate such that the center of the dicing coincides with that for the first dicing step.

With the respective methods of fabricating the semiconductor device as described in the foregoing, the step of forming the bumps spreading over the semiconductor chips adjacent to each other may comprise a step of forming the bumps from a soldered alloy material, and reflow soldering the respective bumps into a spherical shape after the second dicing step.

Further, the bumps spreading over the semiconductor chips adjacent to each other are preferably formed by plating.

At least either of the first dicing step and the second dicing step may be a step of dicing by means of laser irradiation using a laser device. In such a case, for the laser device, use is preferably made of any one model or several models, selected from the group consisting of an excimer laser device, a YAG laser device, and a carbon dioxide gas laser device.

With a structure for mounting the semiconductor device, according to the invention, a sidewall face of the semiconductor chip composing the semiconductor device is opposite the circuit board, and the bumps overhanging from the sidewall face are connected with electrically conductive patterns or electrodes, provided on the circuit board.

Also, the invention provides a structure for mounting the semiconductor device, wherein a plurality of the bumps are provided so as to overhang from two sidewall faces of a semiconductor chip, respectively, and a sidewall face on one side of the semiconductor chip is opposite a circuit board while a sidewall face on the other side of the semiconductor chip is opposite a flexible printed circuit board (FPC), the bumps overhanging from the sidewall face on the one side being connected with electrically conductive patterns or electrodes provided on the circuit board, respectively, while the bumps overhanging from the sidewall face on the other side are connected with electrically conductive patterns or electrodes provided on the FPC, respectively.

In the case where the bumps are formed of a soldered alloy material, the bumps in a melted shape are connected with electrically conductive patterns or electrodes provided on the circuit board or the FPC.

The bumps are preferably connected with electrically conductive patterns or electrodes provided on the circuit board or the FPC by solder or an anisotropic conductive adhesive.

A method of mounting a semiconductor device according to the invention, is a method whereby the semiconductor device provided with the plurality of the bumps electrically conductive with the respective electrode pads provided in the vicinity of the side edge of the semiconductor chip formed so as to overhang from a sidewall face of the semiconductor chip, is mounted on a circuit board, wherein the method comprises a step of disposing the semiconductor device such that the sidewall face of the semiconductor chip is opposite the circuit board, and a step of placing an anisotropic conductive adhesive between the bumps overhanging from the sidewall face of the semiconductor chip and the circuit board.

Further, a step of electrically connecting the bumps with electrically conductive patterns or electrodes provided on the circuit board by applying heat treatment between the bumps and the circuit board while applying pressure thereto.

Further, a method of mounting the semiconductor device provided with the plurality of the bumps made of the soldered alloy material formed so as to overhang from a sidewall face of the semiconductor chip on a circuit board comprises a step of disposing the semiconductor device such that the sidewall face of the semiconductor chip is opposite the circuit board and a step of melting the bumps overhanging from the sidewall face of the semiconductor chip by applying heat treatment thereto, and electrically connecting the bumps with electrically conductive patterns or electrodes provided on the circuit board.

Further, the invention provides a method of mounting the semiconductor device provided with the plurality of bumps electrically conductive with the respective electrode pads provided in the vicinity of the side edges of the semiconductor chip formed so as to overhang from two sidewall faces of the semiconductor chip, respectively, on the circuit board and the FPC.

In such a case, the method comprise a step of disposing the semiconductor device such that the sidewall face on one side of the semiconductor chip is opposite the circuit board, a step of placing an anisotropic conductive adhesive between the bumps overhanging from the sidewall face on the one side of the semiconductor chip and the circuit board, and a step of electrically connecting the bumps with electrically conductive patterns or electrodes provided on the circuit board by applying heat treatment between the bumps and the circuit board while applying pressure thereto.

The method further comprises a step of disposing thereafter or at the same time the semiconductor device and the FPC such that the sidewall face on the other side of the semiconductor chip is opposite the FPC, a step of placing an anisotropic conductive adhesive between the bumps overhanging from the sidewall face on the other side of the semiconductor chip and the FPC, and a step of electrically connecting the bumps with electrically conductive patterns or electrodes provided on the FPC by applying heat treatment between the bumps and the FPC while applying pressure thereto.

Further, the bumps of the semiconductor device may be connected with the electrically conductive patterns or electrodes provided on the circuit board or the FPC by use of solder in place of the anisotropic conductive adhesive.

### BRIEF DESCRIPTION OF THE DRAWINGS

Fig. 1 is a sectional view showing a first embodiment of a semiconductor device according to the invention;
Figs. 2 to 9 are sectional views showing respective steps of a method of fabricating the semiconductor device shown in Fig. 1;
Fig. 10 is a sectional view showing an example of a structure for mounting the semiconductor device shown in Fig. 1 on a liquid crystal display device;
Fig. 11 is a sectional view of a principal part of a second embodiment of a semiconductor device according to the invention;
Fig. 12 is a sectional view showing an example of a structure for mounting the semiconductor device shown in Fig. 11 on a liquid crystal display device;
Fig. 13 is a sectional view showing a third embodiment of a semiconductor device according to the invention;
Figs. 14 to 20 are sectional views showing respective steps of a method of fabricating the semiconductor device shown in Fig. 13;
Fig. 21 is a sectional view showing an example of a structure for mounting the semiconductor device shown in Fig. 13 on a liquid crystal display device;
Fig. 22 is a perspective view of the structure for mounting the semiconductor device shown in Fig. 21, showing a relationship of the semiconductor device with the substrate of the liquid crystal display device, and with the FPC;
Fig. 23 is a plan view showing a part of the liquid crystal display device with the semiconductor device shown in Fig. 22 mounted thereon and the FPCs connected thereto;
Fig. 24 is a perspective view of another example of a structure for mounting the semiconductor device according to the invention, showing a relationship of the semiconductor device with the substrate of the liquid crystal display device and with the FPC;
Fig. 25 is a plan view showing a part of the liquid crystal display device with the semiconductor device shown in Fig. 24 mounted thereon and the FPCs connected thereto;
Fig. 26 is a sectional view showing an example of a conventional semiconductor device provided with bumps; and
Fig. 27 is a sectional view showing a conventional structure for mounting a conventional semiconductor device shown in Fig. 26 on a liquid crystal display device.

### BEST MODE FOR CARRYING OUT THE INVENTION

Preferred embodiments of a semiconductor device, a method of fabricating the same, a structure for mounting the same and a method of mounting the same according to the invention are described hereinafter with reference to the accompanying drawings.

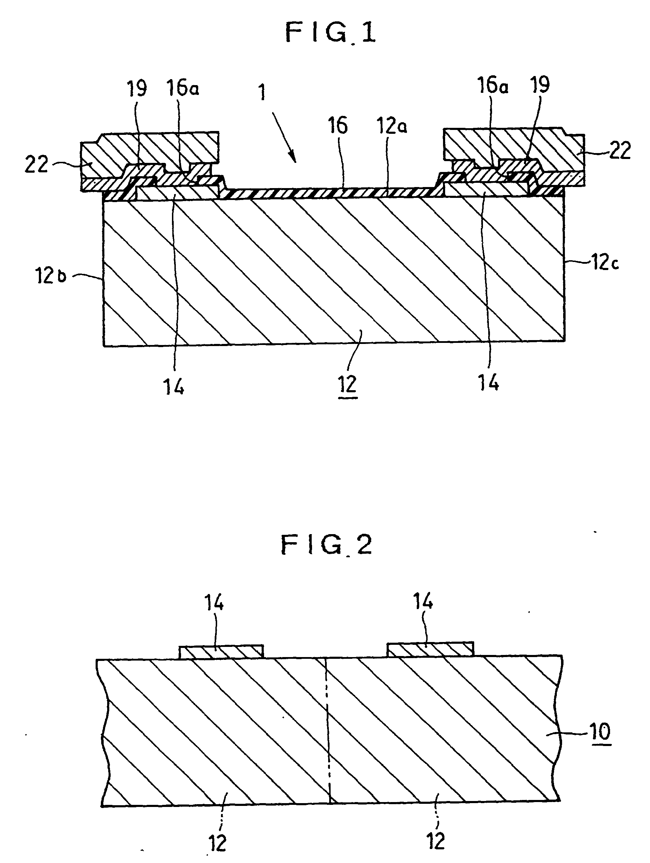

### First Embodiment of a Semiconductor Device: Fig. 1

A first embodiment of a semiconductor device according to the invention is described hereinafter with reference to Fig. 1. Fig. 1 is a sectional view showing the construction of the first embodiment of the semiconductor device according to the invention.

The semiconductor device 1 comprises: a semiconductor chip 12 provided with an integrated circuit (not shown) formed thereon and a plurality of electrode pads 14 for connecting the integrated circuit to an external circuit disposed in the vicinity of side edges (in this example, an edge of respective sidewall faces 12b, 12c, running in the direction orthogonal to the plane of the figure) of a surface 12a thereof; an insulating film 16 formed on top of the semiconductor chip 12, having an opening 16a formed over the respective electrode pads 14 and covering a peripheral region of the respective opening pads 14; a plurality of lower electrodes 19 provided on top of the insulating film 16, each electrically conductive with the respective electrode pads 14 through the respective openings 16a; and a plurality of protruded electrodes (bumps) 22, each provided on top of the respective lower electrodes 19.

Both the respective bumps 22 and the respective lower electrodes 19 are formed so as to overhang to an extent of about 10 to 50 µm from either the sidewall face 12b of the semiconductor chip 12 or the sidewall face 12c thereof.

Further, the respective bumps 22 and the respective lower electrodes 19 are patterned such that the respective bumps 22 are formed in a planar shape somewhat larger than that for the respective lower electrodes 19.

The bumps 22 can be made of a single constituent material having a high conductivity such as copper (Cu), gold (Au), nickel (Ni), indium (In), and so forth.

It is most desirable to compose the bumps 22 from gold (Au) so as to prevent oxidation of an upper surface thereof, however, since gold is expensive, the bumps 22 are preferably composed of a lower layer made of copper or nickel and an upper layer (a surface layer) made of gold. Further, the bumps 22 may be composed of a soldered alloy material that is easily melted. For such a soldered alloy material, there is available lead (Pb), tin (Sn), silver (Ag), indium (In), and bismuth (Bi).

### First Embodiment of a Method of Fabricating the Semiconductor Device: Figs. 2 to 9

A method of fabricating the semiconductor device shown in Fig. 1 is described hereinafter with reference to Figs. 2 to 9. Figs. 2 to 9 are sectional views showing respective steps of the method of fabricating the semiconductor device shown in Fig. 1.

First, a semiconductor substrate (wafer) 10 shown in Fig. 2 is prepared. The semiconductor substrate 10 is provided with integrated circuits (not shown) comprising a multitude of active elements, passive elements, and so forth for a plurality of semiconductor chips, and a plurality of electrode pads made of aluminum for connecting the integrated circuits with an external circuit. In Fig. 2, only a portion of the semiconductor substrate 10 is shown, and electrode pads 14, 14 for respective two semiconductor chips 12, 12 adjacent to each other are shown.

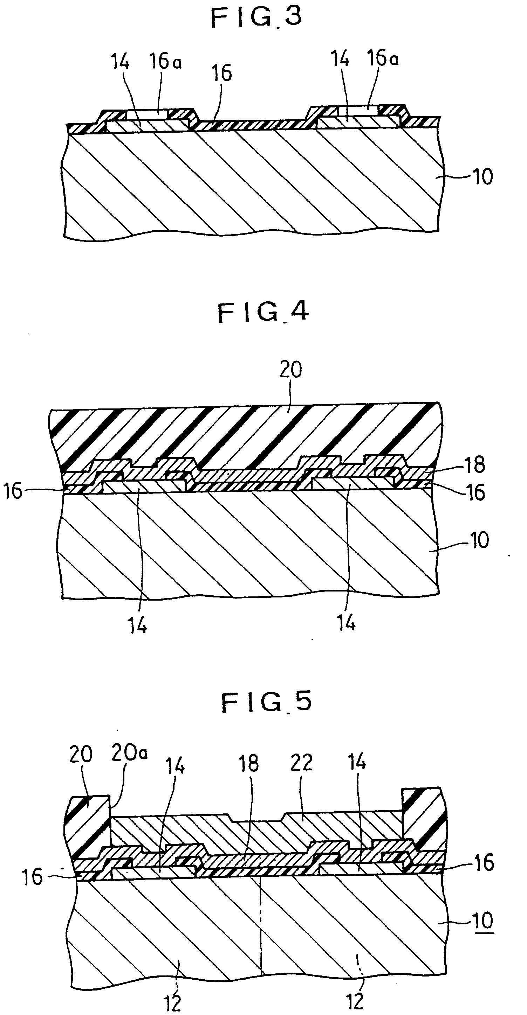

In a first step, as shown in Fig. 3, the insulating film 16 provided with the opening 16a over the respective electrode pads 14 is formed on the semiconductor substrate 10.

For the insulating film 16, silicon nitride (Si₃N₄) is adopted as a constituent material thereof, and the insulating film 16 is formed to a thickness of 1 µm on the entire upper surface of the semiconductor substrate 10 by means of the plasma chemical vapor deposition (CVD) method.

The constituent material for the insulating film 16 is not limited to silicon nitride, and for the insulating film 16, an inorganic film made of silicon dioxide (SiO₂), tantalum oxide (Ta₂O₅), aluminum oxide (Al₂O₃), or so forth is effective as well. Further, a multi-layer film composed of these films can be used as well.

In addition, an organic film made of polyimide, or so forth can be used for the insulating film 16, and further, a multi-layer film composed of the inorganic film and the organic film may be used instead.

A method of forming the insulating film 16 is not limited to the plasma CVD method, and the insulating film 16 can be formed by the sputtering method as well.

After forming the insulating film 16 on the entire upper surface of the semiconductor substrate 10, a photosensitive resin (photoresist) is formed on the entire upper surface of the insulating film 16 although not shown, the photoresist is patterned in a photolithographic step wherein exposure and development treatments are applied thereto by use of a predetermined photomask, and the insulating film 16 is then patterned using the patterned photoresist as an etching mask. In this photoetching step, the opening 16a is formed in a region of the insulating film 16 over the respective electrode pads 14.

At this point in time, patterning is performed such that the insulating film 16 covers a peripheral region of the respective electrode pads 14 as shown in Fig. 3.

In subsequent steps, an aluminum film, a chromium film, and a copper film are formed in sequence by the sputtering method to a thickness of 0.8 µm, 0.01 µm, and 0.8 µm, respectively, on the entire upper surface of the semiconductor substrate 10 on which the insulating film 16 provided with the openings 16a is formed, thereby forming a common electrode film 18 of a triple-layer structure as shown in Fig. 4.

As a constituent material for the common electrode film 18, it is necessary to select a stable electrode material that has excellent electrical and mechanical continuity with the electrode pads 14 and an electrode material for the bumps 22 yet to be formed, and that causes no mutual diffusion with these electrode materials.

For this reason, besides the above-described triple-layer structure composed of the aluminum, chromium, and copper, either a bi-layer structure composed of titanium and palladium, titanium and gold, titanium and platinum, titanium-tungsten alloy and palladium, titanium-tungsten alloy and gold, titanium-tungsten alloy and platinum, titanium-tungsten alloy and copper, chromium and copper or so forth, or a triple-layer structure composed of aluminum, titanium, and copper or so forth is effective as the common electrode film 18. In this connection, the uppermost layer of the common electrode film is preferably made of copper because this will make it easier to form the bumps by plating, and further, even if soldering is applied to the surface of copper, melting of copper into solder does not occur upon heating in this case.

In a next step, as shown in Fig. 4, a photosensitive resin film 20 is formed to a thickness of 17 µm on the entire upper surface of the common electrode film 18 by the spin coater method. The photosensitive resin film 20 is used as a plating stop film when forming the bumps 22 by plating during a later step.

Thereafter, the photosensitive resin film 20 is patterned by applying exposure and development treatments thereto using a predetermined photomask such that an opening 20a as shown in Fig. 5 is formed in a region where bumps are to be formed spreading over semiconductor chips adjacent to each other.

In a subsequent step, a copper plating is formed to a thickness ranging from 10 µm to 15 µm using the photosensitive resin film 20 as a plating mask, thereby forming the bumps 22. As a result, the bumps 22 spreading over the semiconductor chips 12, 12 adjacent to each other can be formed on the common electrode film 18 inside the opening 20a of the photosensitive resin film 20 as shown in Fig. 5.

As a constituent material for the bumps 22, use can be made of a metallic material having a high conductivity such as gold, nickel, indium, and so forth besides copper.

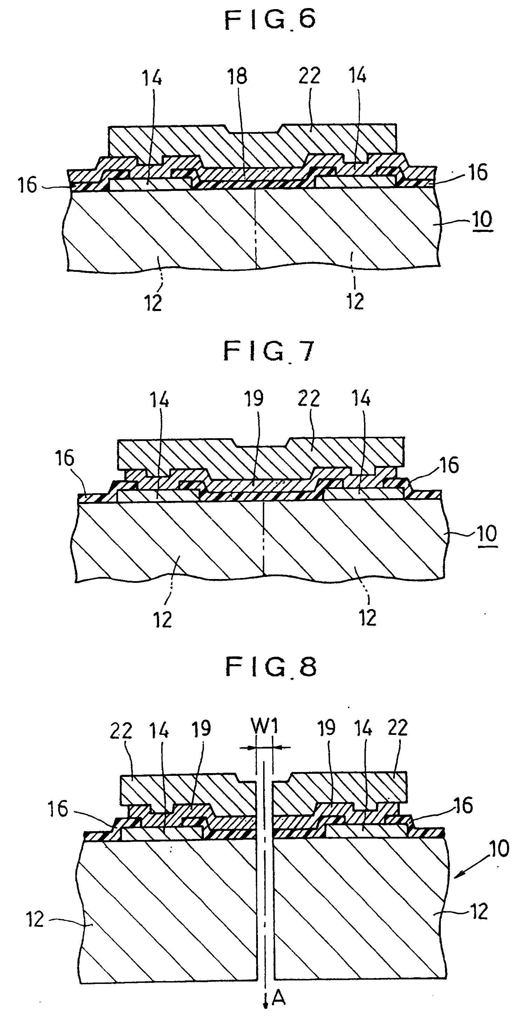

In a subsequent step, the photosensitive resin film 20 that have been used as the plating stop film is removed by use of a wet remover as shown in Fig. 6.

Thereafter, etching of a copper film that is the uppermost layer coating of the common electrode film 18 is carried out with "Enstrip C" (trade name) which is the etchant for copper manufactured by Meltex Inc., using the bumps 22 as an etching mask. This etching treatment is applied for the duration of an over-etching time, 30% longer than that for just etching.

Subsequently, the chromium film (an intermediate layer), serving as a barrier layer as well as an adhesion layer of the common electrode film 18, and the aluminum film (the bottom layer) of the common electrode film 18 are etched with a mixed liquid consisting of ammonium cerium nitrate, potassium ferricyanide, and sodium hydroxide.

This etching treatment is also applied for the duration of an over-etching time, 30% longer than that for just etching.

As a result, lower electrodes 19 spreading over the semiconductor chips 12, 12 adjacent to each other can be formed in a region matching the bumps 22 as shown in Fig. 7. The lower electrodes 19 have the same triple-layer structure composed of the copper film, chromium film, and aluminum film as that for the common electrode film 18. The respective lower electrodes 19 and the respective bumps 22 are patterned such that the respective lower electrodes 19 are formed in a planar shape smaller than that for the respective bumps 22.

Such a difference in planar shape between the respective bumps 22 and the respective lower electrodes 19 is caused to occur primarily due to over-etching of the common electrode film 18 as described in the foregoing.

Thereafter, as shown in Fig. 8, a first dicing step is carded out such that dicing in the direction of the arrow A is applied to the center (boundary) of the semiconductor chips 12, 12 adjacent to each other from the side of the upper surface of the bumps 22, and thereby the bumps 22 and the lower electrodes 19 spreading over the semiconductor chips 12, 12 adjacent to each other, and the semiconductor substrate 10 are cut, thus producing the respective semiconductor chips 12, 12 separated from each other.

At this point in time, dicing with a dicing width W1 is carried out along a center line at a position indicated by a chain line in Fig. 8. In the first dicing step, a dicing blade with a dicing width W1 in the range of 10 to 20 µm is used.

The first dicing is carried out with a dicing tape (not shown) pasted to the rear surface of the semiconductor substrate 10 away from the upper surface on which the bumps 22 are formed. And care should be exercised so as not to cut the dicing tape by dicing, so that the respective semiconductor chips are retained on the dicing tape without coming apart even after the semiconductor substrate 10 is cut.

After completion of the first dicing step, a dicing tape (not shown) is pasted to the upper surface of the semiconductor substrate 10, provided with the bumps 22 formed thereon, and the dicing tape pasted to the rear surface of the semiconductor substrate 10 is peeled off therefrom by means of ultraviolet irradiation.

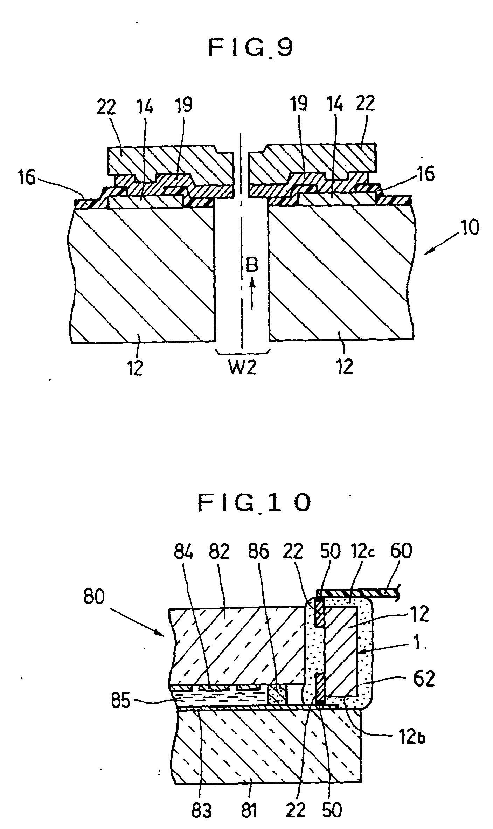

Subsequently, as shown in Fig. 9, a second dicing step is carried out such that dicing of the semiconductor substrate 10 with a dicing width W2 wider than the dicing width W1 for the first dicing step is executed in the direction of the arrow B from the side of the rear surface of the semiconductor substrate 10 such that the center (as indicated by a chain line in the figure) of such dicing coincides with that for the first dicing step.

In the second dicing step, a dicing blade with a dicing width W2 in the range of 30 to 70 µm is used.

As a result, the lower electrode 19 and the bump 22 overhanging from a sidewall face of the respective semiconductor chips 12, that is, a cut face of the semiconductor substrate 10 can be formed with ease, and by peeling off the dicing tape, the individual semiconductor device as shown in Fig. 1 can be obtained.

With the method of fabricating the semiconductor device according to the invention, all the steps of fabrication can be executed with the semiconductor substrate (wafer) and the respective semiconductor chips 12 as cut being held together by the dicing tape, so that there is no need of working on every individual semiconductor chip. Accordingly, it is possible to fabricate the semiconductor device 1 provided with the bumps 22 overhanging from opposite sidewall faces of the semiconductor chip 12, respectively, as shown in Fig. 1, quite efficiently, and yet at a high yield.

In the example shown in Fig. 9, dicing is carried out up to the insulating film 16 during the second dicing step, however, dicing of the semiconductor substrate 10 only may be carried out instead.

In the first dicing step, the second dicing step, or both thereof, dicing may be carried out by laser irradiation with a laser device instead of the dicing using the dicing blade.

In such a case, an excimer laser device, YAG laser device, carbon dioxide gas laser device, or so forth is preferably used as the laser device.

### Structure for Mounting the Semiconductor Device and Method of Mounting Same: Fig. 10

Now, a structure for mounting the first embodiment of the semiconductor device according to the invention as shown in Fig. 1 on a circuit board, that is, a substrate of a liquid crystal display device, is described hereinafter with reference to Fig. 10.

Reference numeral 80 denotes a liquid crystal display device, and respective parts composing a liquid crystal display panel thereof corresponding to those of the conventional liquid crystal display device shown in Fig. 27 are denoted by like reference numerals.

The semiconductor device 1 for driving the liquid crystal display device 80 is mounted in the liquid crystal display device 80 comprising a first substrate 81 that is a glass substrate provided with scanning electrodes 83 formed thereon, a second substrate 82 that is a glass substrate provided with signal electrodes 84 opposite the scanning electrodes 83 formed thereon, and liquid crystal 85 sealed therein-between with a sealing material 86.

As described hereinbefore with reference to Fig. 1, the semiconductor device 1 is provided with the plurality of the bumps 22 formed on the upper surface of the semiconductor chip 12 with an integrated circuit formed thereon, overhanging from the sidewall face 12b on one side of the semiconductor chip 12, and the sidewall face 12c on the other side thereof, parallel to each other, respectively.

With the semiconductor device 1, the sidewall face 12b on the one side of the semiconductor chip 12 thereof is opposite the first substrate 81 (serving as the circuit board) of the liquid crystal display device, and the plurality of the bumps 22 overhanging from the sidewall face 12b are connected via an anisotropic conductive adhesive 50 with an extension of the respective scanning electrodes 83 that are a plurality of electrically conductive patterns formed on the first substrate 81, respectively.

Further, the sidewall face 12c on the other side of the semiconductor chip 12 is opposite a flexible printed circuit board (FPC) 60, and the plurality of the bumps 22 overhanging from the sidewall face 12c are connected via an anisotropic conductive adhesive 50 with a plurality of electrically conductive patterns or electrodes provided on the FPC 60, respectively.

Further, a gap between the periphery of the semiconductor device 1 and the first substrate 81 as well as the FPC 60, respectively, is filled up and covered with mold resin 62.

Thus, by electrically and mechanically connecting the sidewall faces of the semiconductor chip 12 of the semiconductor device 1 with the circuit board and the electrodes of the liquid crystal display device as described above, an area required for mounting the semiconductor device on the substrate of the liquid crystal display device can be significantly reduced in comparison with that in the case of the conventional structure for mounting as shown in Fig. 27, so that non-display sections of the liquid crystal display panel are lessened in area, thereby enabling downsizing of the liquid crystal display device to be achieved.

Even in the case of mounting the semiconductor device 1 on a circuit board of an electronic device other than the liquid crystal display device, an area required for mounting the same can be significantly reduced similarly to the case described above, so that downsizing of the electronic device can be achieved.

Now, a method of mounting the semiconductor device on the liquid crystal display device for implementing the structure for mounting the semiconductor device as shown in Fig. 10 is hereinafter described.

The semiconductor device 1 shown in Fig. 1 is disposed such that the sidewall face 12b on one side of the semiconductor chip 12 is opposite the first substrate (circuit board) 81 of the liquid crystal display device 80.

Subsequently, the anisotropic conductive adhesive 50 is placed between the bumps 22 overhanging from the sidewall face 12b of the semiconductor chip 12 of the semiconductor device 1 and the first substrate 81.

The anisotropic conductive adhesive 50 is composed by mixing electrically conductive particles in a bead-like shape with 3 to 6 µm outside diameter formed by applying a bi-layer plating of nickel and gold to spherical plastic particles into an insulating adhesive which, for example, is a thermosetting epoxy based adhesive, at a ratio of about 40% by volume.

Thereafter, heat treatment at a temperature in the range of 180 to 220°C is applied between the bumps 22 and the first substrate 81 while applying pressure at 400 kg / cm² thereto.

As a result, the electrically conductive particles of the anisotropic conductive adhesive 50 are securely held between the bumps 22 overhanging sideways from the sidewall face 12b of the semiconductor device 1 and the extension of the respective scanning electrodes 83 on the first substrate 81 of the liquid crystal display device 80, so that mechanical and electrical connection between the bumps 22 and the scanning electrodes 83 can be achieved.

Further, the semiconductor device 1 is disposed on the side of the liquid crystal display device 80, opposite from a junction between the semiconductor device 1 and the first substrate 81, such that the sidewall face 12c on the other side of the semiconductor chip 12 is opposite the flexible printed circuit board (FPC) 60.

Subsequently, an anisotropic conductive adhesive 50 is disposed between the bumps 22 overhanging from the sidewall face 12c of the semiconductor chip 12 and the FPC 60, and heat treatment at a temperature in the range of 180 to 220°C is applied between the bumps 22 and the FPC 60 while applying pressure at 400 kg / cm² thereto.

As a result, the electrically conductive particles of the anisotropic conductive adhesive 50 are securely held between the respective bumps 22 overhanging from the sidewall face 12c of the semiconductor device 1 and the respective electrically conductive patterns or electrodes on the FPC 60, thereby enabling mechanical and electrical connection between the bumps 22 and the FPC 60 to be achieved.

Thereafter, a gap between the periphery of the semiconductor device 1 and the first and second substrates 81, 82 of the liquid crystal display device 80 as well as the FPC 60, respectively, is filled up and covered with the mold resin 62, thereby preventing moisture from making ingress into respective junctions, and providing the junctions with mechanical protection while securely bonding together the semiconductor device 1, the liquid crystal display device 80, and the FPC 60.

In the foregoing, there has been described a case where a step of joining the bumps 22 overhanging from the sidewall face 12b on the one side of the semiconductor device 1 to the first substrate 81 of the liquid crystal display device 80 and a step of joining the bumps 22 overhanging from the sidewall face 12c on the other side of the semiconductor device 1 to the FPC 60 are carried out in sequence, however, both the steps may be carried out at the same time.

Furthermore, it is also possible to provide the semiconductor device 1 with the bumps 22 formed so as to overhang from two sidewall faces thereof, orthogonal to each other, respectively, and to dispose the semiconductor device 1 such that the two sidewall faces, orthogonal to each other, are opposite the circuit board and the FPC, respectively, so as to be connected therewith via the anisotropic conductive adhesive.

Also, it is possible to use solder for electrical connection of the bumps of the semiconductor device with the electrically conductive patterns or electrodes on the circuit board or the FPC.

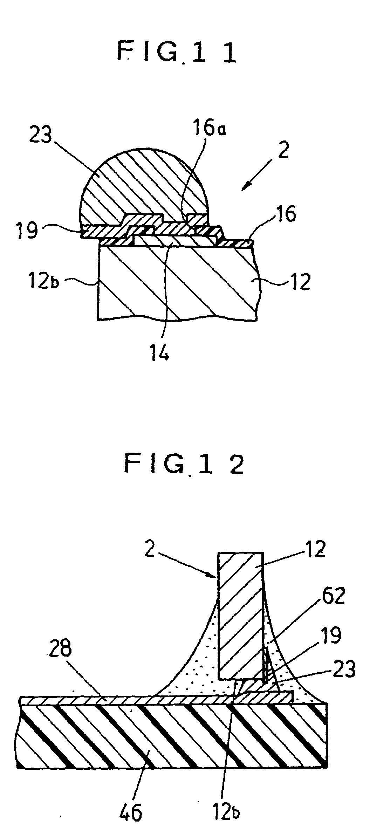

### Second Embodiment: Figs. 11 and 12

A second embodiment of a semiconductor device according to the invention is described hereinafter with reference to Fig. 11, and a structure for mounting the semiconductor device is described with reference to Fig. 12.

Fig. 11 is a sectional view of a principal part of the second embodiment of the semiconductor device according to the invention, and in the figure, parts corresponding to those in Fig. 1 are denoted by the same reference numerals, omitting description thereof.

The semiconductor device 2 differs from the semiconductor device 1 shown in Fig. 1 only in that bumps 23 are made of a soldered alloy material, and are formed in a spherical shape by reflow soldering. A multitude of the bumps 23 and lower electrodes 19 are provided along a side edge of a semiconductor chip 12 running in the direction orthogonal to the plane of the figure, and they are insulated from each other by an insulating film 16 on the semiconductor chip 12, and are formed in such a way as to be individually conductive with respective electrode pads 14 through respective openings 16a of the insulating film 16, and to overhang up to about 10 to 50 µm from a sidewall face 12b of the semiconductor chip 12. Although not shown in the figure, a plurality of bumps 23 and lower electrodes 19 are also provided along another sidewall face, parallel to, or orthogonal to the sidewall face 12b, in such a way as to overhang therefrom.

Now, with reference to a method of fabricating the semiconductor device 2, steps differing from those for the method of fabricating the semiconductor device 1 are described hereinafter.

The method of fabricating the semiconductor device 2 up to steps of forming an insulating film 16 and a common electrode film 18 on the upper surface of a semiconductor substrate 10, forming and patterning a photosensitive resin film 20 on the common electrode film 18, and forming an opening 20a in a region where bumps are to be formed are the same as those for the method of fabricating the semiconductor device 1 as described with reference to Figs. 2 to 5.

Thereafter, in a step of forming the bumps spreading over semiconductor chips 12, 12 adjacent to each other on the common electrode film 18 inside the opening 20a of the photosensitive resin film 20 as shown in Fig. 5, a solder plating is formed to a thickness in the range of 15 to 30 µm, thereby forming the bumps 23 made of a soldered alloy material (referred to hereinafter merely as solder).

In this case, selection is made of such a solder plating bath as will have a post-plating chemical composition of 60% of tin (Sn) and 40% of lead (Pb). Plating is executed at a current density of 2 to 3 A / dm² using a solder plating bath consisting of, for example, "AS-S" (trade name) at 167 g / l, and "AS-P" (trade name) at 16.5 g / l, both manufactured by Harada Industries, including as additives "MS-A" (trade name) at 104 g / l, and "513Y" (trade name) at 30 ml / l.

Thereafter, similarly to the steps described with reference to Figs. 6 to 9, the photosensitive resin 20 is removed by use of a wet remover, lower electrodes 19 are formed by etching the common electrode film 18 using the bumps 23 as an etching mask, and the semiconductor substrate 10 is cut into individual semiconductor chips 12 by carrying out first and second dicing steps, thereby causing the respective bumps 23, and lower electrodes 19 to overhang from a sidewall face (cut face) of the respective semiconductor chips 12.

Subsequently, a step of reflow soldering the respective bumps 23 into a spherical shape is carried out by heating the respective semiconductor chips 12 at a temperature in the range of 230 to 250°C, thereby rounding solder composing the respective bumps 23 as shown in Fig. 11.

Fig. 12 shows an example of a structure for mounting the semiconductor device 2 on a circuit board.

The semiconductor device 2 is disposed such that the sidewall face 12b of the semiconductor chip 12, provided with the bumps 23 overhanging therefrom, is opposite a circuit board 46, and the respective bumps 23 correspond to respective circuit electrodes 28 on the circuit board 46, and heat treatment is applied thereto at the melting point of the bumps 23 ranging from 230 to 250°C.

As a result, the solder composing the respective bumps 23 is melted, thereby rendering the respective bumps 23 electrically conductive with the respective circuit electrodes 28 while mechanically connecting the semiconductor device 2 with the circuit board 46 at the same time.

Thereafter, the front surface as well as the rear surface of the semiconductor device 2, and a junction between the semiconductor device 2 and the circuit board 46 are covered with the mold resin 62 for reinforcement of the junction, thereby enhancing electrical and mechanical reliability of the structure for mounting the semiconductor device.

The circuit board 46 may be the first substrate 81 of the liquid crystal display device 80 shown in Fig. 10 or a circuit board of other devices.

With the example shown in Fig. 12, the FPC 60 shown in Fig. 10 is not connected to the semiconductor device 2. However, with this embodiment as well, bumps 23 overhanging from another sidewall face of the semiconductor chip 12 parallel to or orthogonal to the sidewall face 12b can be provided, and the FPC can be disposed opposite the former sidewall face, so that the bumps 23 are caused to melt, and to be electrically connected with electrically conductive patterns or electrodes on the FPC, thereby enabling mechanical connection of the semiconductor device 2 with the FPC to be achieved at the same time.

Similarly to the case of the previously-described embodiment, an anisotropic conductive adhesive or solder may be used for connection of the bumps 23 with the FPC.

In this case, use is made of an anisotropic conductive adhesive having a setting temperature lower than the melting point of the solder of the bumps 23 used for joining the bumps 23 with the circuit board 46, and similarly, for joining the bumps 23 with the FPC, use is made of solder having the melting point lower than the melting point of the solder of the bumps 23 used for joining the bumps 23 with the circuit board 46.

With the second embodiment of the invention as well, an area required for mounting the semiconductor device on the circuit board can be reduced, so that a highly reliable structure suitable for high-density mounting of the semiconductor device can be implemented.

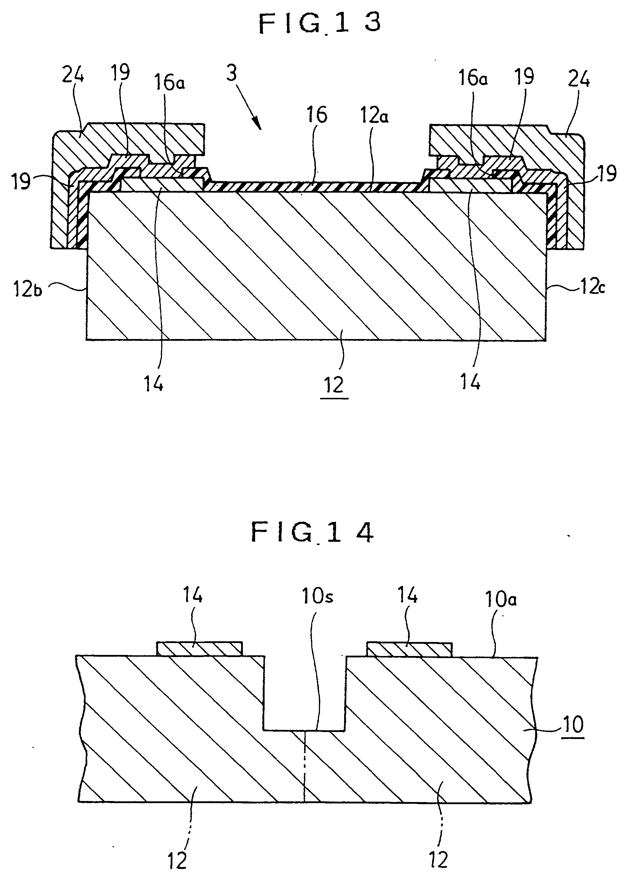

### Third Embodiment: Figs. 13 to 25

A third embodiment of a semiconductor device according to the invention is next described.

Fig. 13 is a sectional view showing the construction of the third embodiment of the semiconductor device according to the invention, and in the figure, parts corresponding to those in Fig. 1 except for a semiconductor device 3 and bumps 24 are denoted by the same reference numerals.

As shown in Fig. 13, the semiconductor device 3 differs from the semiconductor device 1 shown in Fig. 1 only in that an insulating film 16, respective lower electrodes 19, and respective bumps 24 are provided so as to be extended from the upper surface 12a of a semiconductor chip 12 with electrode pads 14 provided thereon onto a sidewall face 12b or 12c in such a way as to overhang therefrom. With the semiconductor device constructed as above, an area of a junction between the respective bumps thereof and a circuit board or an FPC can be increased, thereby enabling more reliable connection therebetween to be achieved.

Similarly to the bumps 22 according to the first embodiment, the bumps 24 may as well be made of a single constituent material having high conductivity such as copper (Cu), gold (Au), nickel (Ni), indium (In), or so forth, or may be composed of an underlying layer made of copper or nickel, and an upper layer (surface layer) made of gold (Au). Otherwise, the bumps 24 may be made of a soldered alloy material.

Now, a method of fabricating the semiconductor device 3 is described hereinafter with reference to Figs. 14 to 20. Figs. 14 to 20 are sectional views showing respective steps of the method of fabricating the semiconductor device shown in Fig. 13. With this method of fabricating the semiconductor device, description of steps similar to those for the method of fabricating the semiconductor device according to the first embodiment of the invention as described with reference to Figs. 2 to 9 is omitted.

As shown in Fig. 14, a groove 10s about 100 µm in width and about 200 µm in depth is first formed in the central region between the electrode pads 14, 14, for two semiconductor chips 12, 12 adjacent to each other of a semiconductor substrate (wafer) 10, respectively, from the side of the upper surface 10a of the semiconductor substrate 10 with the electrode pads 14, 14 provided thereon.

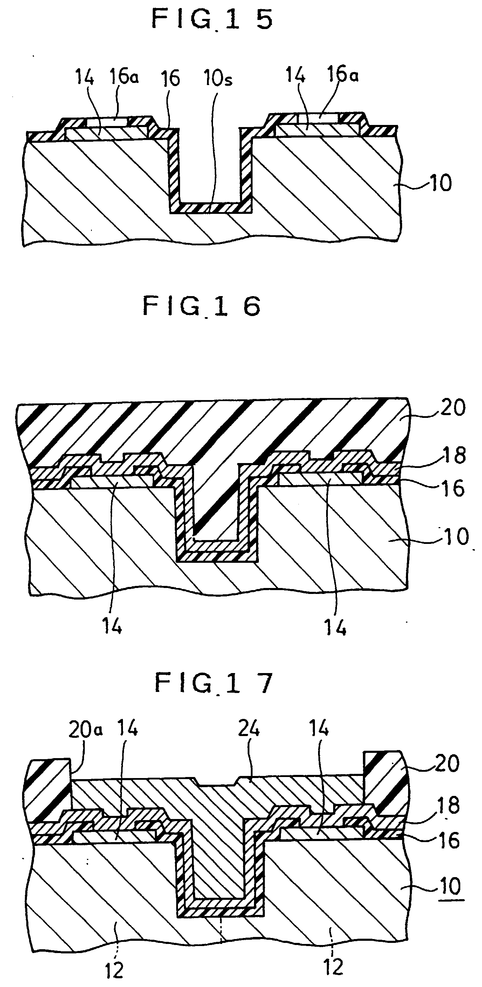

Subsequently, as shown in Fig. 15, an insulating film 16 having an opening 16a provided over the respective electrode pads 14 is formed on the upper surface 10a of the semiconductor substrate 10 and on the entire inner surface of the groove 10s.

The insulating film 16 is formed of, for example, silicon nitride (Si₃N₄) to a thickness of 1 µm by the plasma CVD method or the sputtering method. Otherwise, for the insulating film 16, an inorganic film made of silicon dioxide (SiO₂), tantalum oxide (Ta₂O₅), aluminum oxide (Al₂O₃) or so forth, or a multi-layered film composed of the inorganic films may be formed. In addition, an organic film made of polyimide or so forth, or a multi-layered film composed of the inorganic film and the organic film may be used instead.

The openings 16a of the insulating film 16 are formed by applying an etching treatment to the insulating film 16 using a photosensitive resin film after patterned as a mask.

In a subsequent step, an aluminum film, a chromium film, and a copper film are formed in sequence to a thickness of 0.8 µm, 0.01 µm, and 0.8 µm, respectively, on the entire surface of the semiconductor substrate 10 on which the insulating film 16 provided with the openings 16a is formed, including the inner surface of the groove 10s, thereby forming a common electrode film 18 of a triple-layer structure as shown in Fig. 16.

Thereafter, as shown in Fig. 16, a photosensitive resin film 20 is formed on the entire surface of the common electrode film 18 by the spin coater method, and the photosensitive resin film 20 is patterned by applying exposure and development treatments thereto using a predetermined mask such that an opening 20a as shown in Fig. 17 is formed in a region where the bumps are to be formed, spreading over semiconductor chips adjacent to each other.

In a subsequent step, copper plating is carried out using the photosensitive resin film 20 as plating masks. As a result, the bumps 24 spreading over the semiconductor chips 12, 12 adjacent to each other can be formed on the common electrode film 18 inside the opening 20a of the photosensitive resin film 20 as shown in Fig. 17. The bumps 24 are formed, filling up the groove 10s of the semiconductor substrate 10. For a constituent material of the bumps 24, use can be made of a metallic material having a high conductivity such as gold, nickel, indium, and so forth besides copper.

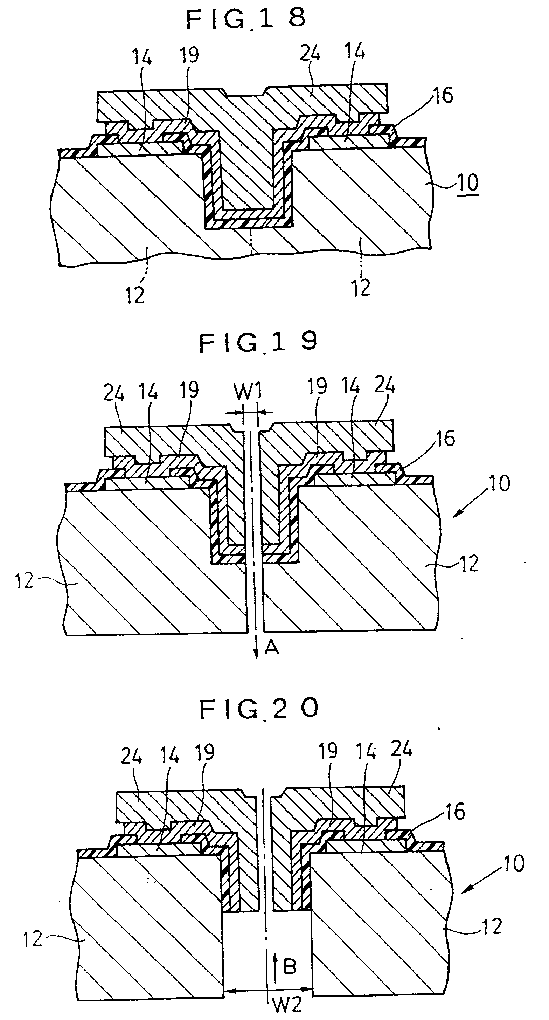

In a subsequent step, as shown in Fig. 18, the portions of the photosensitive resin film 20 that have been used as a plating stop film are removed, and similarly to the case of the first embodiment, the common electrode film 18 is etched by use of the bumps 24 as an etching mask, thereby forming the lower electrodes 19.

A difference in planar shape between the respective bumps 24 and the respective lower electrodes 19 is caused to occur due to over-etching of the common electrode film 18.

Thereafter, a dicing tape (not shown) is pasted to the rear surface of the semiconductor substrate 10, and a first dicing step is carried out such that dicing in the direction of the arrow A is applied to the center (boundary) between the semiconductor chips 12, 12 adjacent to each other from the side of the upper surface of the bumps 24 as shown in Fig. 19, thereby cutting the bumps 24 as well as the lower electrodes 19 spreading over the semiconductor chips adjacent to each other, and the semiconductor substrate 10 to obtain the individual semiconductor chips 12, 12. In this case, a dicing width W1 is in the order of 10 µm to 20 µm.

Subsequently, a dicing tape (not shown) is pasted to the upper surface of the semiconductor substrate 10 with the bumps 24 formed thereon, and the dicing tape pasted to the rear surface of the semiconductor substrate 10 is peeled off therefrom by means of ultraviolet irradiation.

Thereafter, as shown in Fig. 20, a second dicing step is carried out such that dicing of the semiconductor substrate 10 with a dicing width W2 wider than the dicing width W1 for the first dicing step is executed in the direction of the arrow B from the side of the rear surface of the semiconductor substrate 10 such that the center (as indicated by a chain line in the figure) of dicing coincides with that for the first dicing step. In this case, the dicing width W2 is the same as the width of the groove 10s, and in the case of this example, is 100 µm.

In the example shown in Fig. 20, a portion of the insulating film 16 as well as the lower electrodes 19, formed on the bottom of the groove 10s, are removed along with a portion of the semiconductor substrate 10 during the second dicing step, however, dicing of only the portion of the semiconductor substrate 10 or dicing up to only the portion of the insulating film 16 may be carried out.

With this method, the lower electrode 19 and the bumps 24, overhanging from a sidewall face of the respective semiconductor chips 12, that is, a cut face of the semiconductor substrate 10, and extended along the sidewall face can be formed with ease, so that the individual semiconductor device as shown in Fig. 13 can be obtained by peeling off the dicing tape.

In the first dicing step, the second dicing step, or both thereof, dicing can be carried out by use of a dicing blade, or by means of laser irradiation with a laser device.

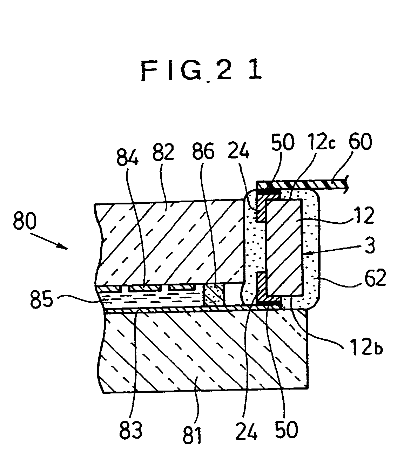

Fig. 21 is a sectional view showing a structure for mounting the third embodiment of the semiconductor device according to the invention on a liquid crystal display device, and the structure for mounting the semiconductor device differs from one shown in Fig. 10 only in that the respective bumps 24 of the semiconductor device 3 are not only overhanged from the sidewall face 12b or 12c of the semiconductor chip 12 but are also extended along the sidewall face 12b or 12c.

With the structure for mounting as described above, an area of a junction between the respective bumps 24 of the semiconductor device 3 and the first substrate 81 or the FPC 60 is increased, thus ensuring more reliable connection therebetween.

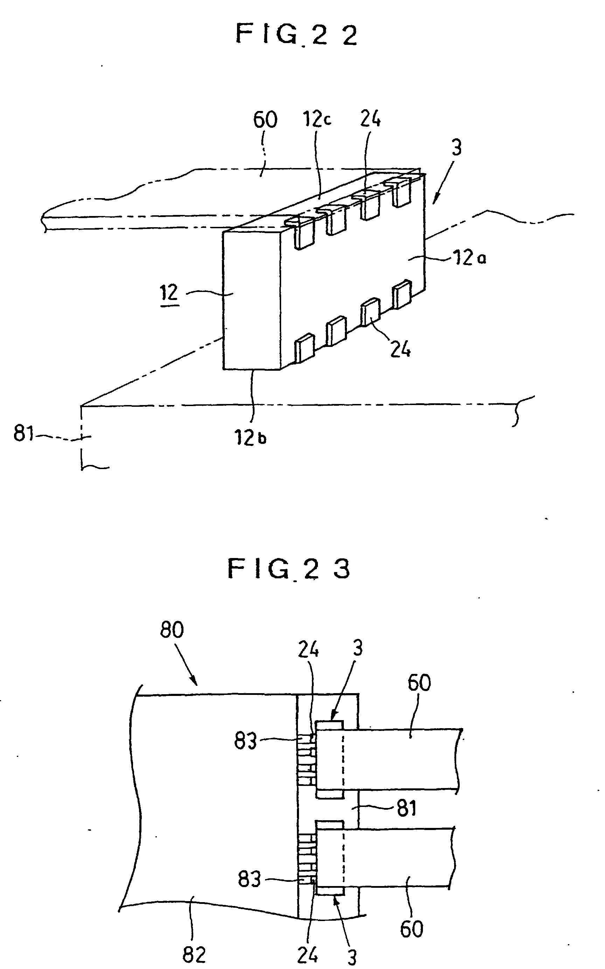

The structure for mounting the semiconductor device 3 on the liquid crystal display device is further described hereinafter with reference to Figs. 22 to 25.

With the semiconductor device 3 shown in Fig. 13, the bumps 24 formed in an L-shape provided on the surface 12a of the semiconductor chip 12 extending therefrom along the first sidewall face 12b are disposed in lines at a spacing in the longitudinal direction. The other bumps 24 formed in an L-shape provided on the surface 12a of the semiconductor chip 12 extending therefrom along the second sidewall face 12c on the side of the semiconductor chip 12 opposite and in parallel with the first sidewall face 12b are also disposed in lines at a spacing in the longitudinal direction as shown in Fig. 22.

In this case, as shown in Fig. 21, the semiconductor device 3 is disposed on the upper face of the first substrate 81 of the liquid crystal display device 80 such that the first sidewall face 12b of the semiconductor chip 12 is opposite to the first substrate 81, and an end portion of the FPC 60 is connected with the second sidewall face 12c. in Fig. 22, the first substrate 81 and the FPC 60 are indicated by phantom lines.

Fig. 23 is a plan view showing a part of the liquid crystal display device 80 in which the semiconductor devices 3 are mounted, and to which the FPCs 60 are connected.

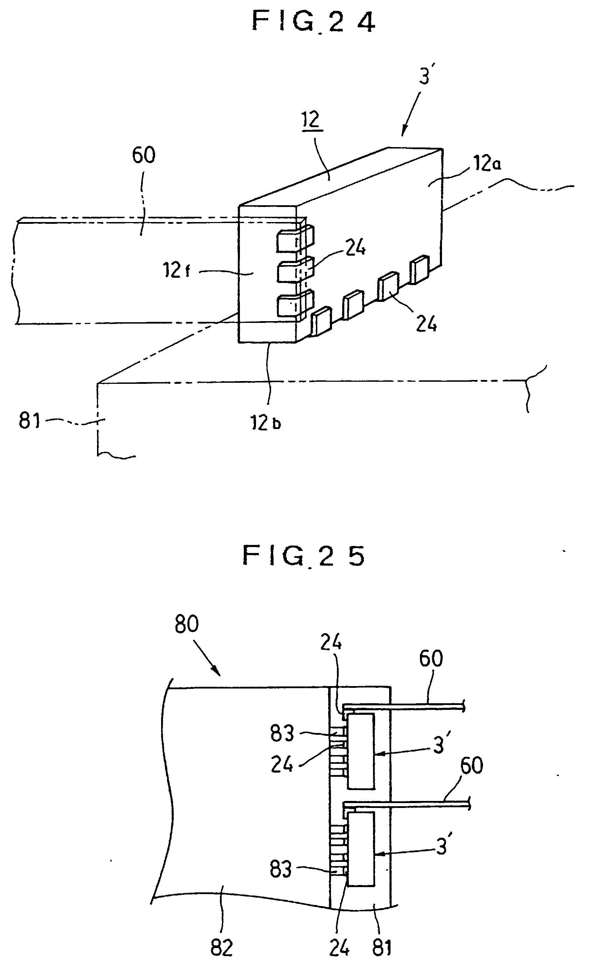

Figs. 24 and 25 are views similar to Figs. 22 and 23, showing an example of another embodiment different from the previously-described embodiment.

With a semiconductor device 3' according to this example, bumps 24 are provided on the surface 12a of a semiconductor chip 12 extending therefrom along a first sidewall face 12b while other bumps 24 are provided on the surface 12a of the semiconductor chip 12 extending therefrom along a third sidewall face 12f of the semiconductor chip 12 orthogonal to the first sidewall face 12b. In other respects, the semiconductor device 3' is the same in construction as the semiconductor device 3 shown in Fig. 13.

As shown in Figs. 24 and 25, the semiconductor device 3' is mounted on a liquid crystal display device such that the first sidewall face 12b of the semiconductor chip 12 is opposite and bonded to the upper surface of a potion of a first substrate 81 of a liquid crystal display device 80 overhanging a second substrate 82 thereof, thereby connecting the respective bumps 24 provided on the surface 12a of the semiconductor chip 12 extending therefrom along the first sidewall face 12b with respective scanning electrodes 83 on the first substrate 81. Further, the respective FPCs 60 are connected to the third sidewall face 12f of the respective semiconductor chips 12, thereby causing the respective bumps 24 provided on the upper surface 12a of the semiconductor chip 12 extending therefrom along the third sidewall face 12f to be electrically conductive with a printed wiring of the respective FPCs 60.

The construction as described above, results in a decrease in the dimensions of the liquid crystal display device, thicknesswise, and this is advantageous in fabricating a flat-type liquid crystal display device.

In Figs. 10 and 21, the examples wherein the semiconductor device according to the invention is mounted on the circuit board that is a glass substrate composing the liquid crystal display device, respectively. However, it is evidently possible to mount the semiconductor device according to the invention on a common circuit board using an epoxy resin substrate, an epoxy resin based substrate with glass fiber mixed therein, a ceramic substrate, or so forth.

### INDUSTRIAL APPLICABILITY

As is evident from the foregoing description, with the semiconductor device, the structure for mounting the same, and the method of mounting the same according to the invention, the semiconductor device can be connected with the circuit board or the flexible printed circuit board via a sidewall face of the semiconductor device, thereby enabling an area of junctions to be downsized, and connection to be rendered highly reliable.

As a result, it becomes possible to realize high density mounting of semiconductor devices on a liquid crystal display device, and so forth, thereby achieving downsizing of electronic devices.

Furthermore, with the method of fabricating a semiconductor device according to the invention, the semiconductor device provided with bumps overhanging from the sidewall faces of a semiconductor chip thereof can be fabricated at a very high productivity and efficiently.

## Claims

1. A semiconductor device comprising:
a semiconductor chip provided with an integrated circuit, and a plurality of electrode pads for connecting the integrated circuit to an external circuit;
an insulating film having an opening over the respective electrode pads, formed on the semiconductor chip in such a way as to cover the peripheral region of the respective electrode pads;
a plurality of lower electrodes provided on the insulating filmis such a way as to be electrically conductive with the respective electrode pads through the respective openings of the insulating film; and
a plurality of bumps provided on the respective lower electrodes in such a way as to overhang from respective sidewall faces of the semiconductor chip.

2. A semiconductor device according to claim 1, wherein both the lower electrodes and the bumps overhang from the respective sidewall faces of the semiconductor chip.

3. A semiconductor device according to claim 2, wherein the respective bumps are patterned in a planar shape larger than that for the respective lower electrodes.

4. A semiconductor device according to claim 2, wherein the insulating film, the respective lower electrodes, and the respective bumps are provided so as to be extended from the surface of the semiconductor chip with the electrode pads provided thereon onto the respective sidewall faces.

5. A semiconductor device according to claim 1, wherein the bumps are made of a single constituent material having a high conductivity, selected from the group consisting of copper, gold, nickel, and indium.

6. A semiconductor device according to claim 1, wherein the bumps are composed of an underlying layer made of a metal selected from the group consisting of copper and nickel, and an upper layer made of gold.

7. A semiconductor device according to claim 1, wherein the bumps are made of a soldered alloy material.

8. A method of fabricating a semiconductor device comprising:
a step of forming an insulating film provided with an opening over each of a plurality of electrode pads formed on a semiconductor substrate provided with integrated circuits for a plurality of semiconductor chips and the plurality of the electrode pads for connecting the integrated circuits with an external circuit;
a step of forming a common electrode film connected with the respective electrode pads through the respective openings on the entire upper surface of the semiconductor substrate with the insulating film formed thereon;
a step of forming a photosensitive resin on the entire upper surface of the common electrode film, and patterning the photosensitive resin film such that an opening is formed in a region where bumps are to be formed, spreading over the semiconductor chips adjacent to each other;
a step of forming the bumps spreading over the semiconductor chips adjacent to each other on the common electrode film inside the opening of the photosensitive resin film;
a step of patterning the common electrode film using the bumps as an etching mask after removing the photosensitive resin thereby forming lower electrodes spreading over the semiconductor chips adjacent to each other;
a first dicing step of cutting the bumps as well as the lower electrodes spreading over the semiconductor chips adjacent to each other, and the semiconductor substrate at the center between the semiconductor chips adjacent to each other from the side of the upper surface of the bumps; and
a second dicing step of performing dicing of the semiconductor substrate with a dicing width wider than tat for the first dicing step from the side of the rear surface of the semiconductor substrate such that the center of the dicing coincides with that for the first dicing step.

9. A method of fabricating a semiconductor device according to claim 8, wherein the step of forming the bumps spreading over the semiconductor chips adjacent to each other comprises a step of forming the bumps from a soldered alloy material, and reflow soldering the respective bumps into a spherical shape after the second dicing step.

10. A method of fabricating a semiconductor device according to claim 8, wherein the step of forming the bumps spreading over the adjacent semiconductor chips is a step of forming the bumps by plating.

11. A method of fabricating a semiconductor device according to claim 8, wherein at least either of the first dicing step and the second dicing step is a step of dicing by means of laser irradiation using a laser device.

12. A method of fabricating a semiconductor device according to claim 11, wherein, for the laser device, use is made of any one model or several models, selected from the group consisting of an excimer laser device, a YAG laser device, and a carbon dioxide gas laser device.

13. A method of fabricating a semiconductor device comprising:
a step of forming a groove in a predetermined width and depth in the central region between semiconductor chips adjacent to each other of a semiconductor substrate provided with integrated circuits for a plurality of semiconductor chips and a plurality of electrode pads for connecting the integrated circuits with an external circuit, from the side of the upper surface of the semiconductor substrate with the electrode pads formed thereon;
a step of forming an insulating film on the upper surface of the semiconductor substrate and on the entire inner surface of the groove, and providing an opening in a region of the insulating film over the respective electrode pads;
a step of forming a common electrode film connected with the respective electrode pads through the respective openings on the entire upper surface of the semiconductor substrate with the insulating film formed thereon including the inner surface of the groove;
a step of forming a photosensitive resin on the entire upper surface of the common electrode film, and patterning the photosensitive resin film such that an opening is formed in a region where bumps are to be formed spreading over the semiconductor chips adjacent to each other;
a step of forming the bumps spreading over the semiconductor chips adjacent to each other, on the common electrode film inside the opening of the photosensitive resin film, including the inner surface of the groove;
a step of patterning the common electrode film using the bumps as an etching mask after removing the photosensitive resin, thereby forming lower electrodes spreading over the semiconductor chips adjacent to each other;
a first dicing step of cutting the bumps as well as the lower electrodes spreading over the semiconductor chips adjacent to each other, and the semiconductor substrate at the center of the groove from the side of the upper surface of the bumps; and
a second dicing step of performing dicing of the semiconductor substrate with a dicing width corresponding to a width of the groove, from the side of the rear surface of the semiconductor substrate such that the center of the dicing coincides with that for the first dicing step.

14. A method of fabricating a semiconductor device according to claim 13, wherein the step of forming the bumps spreading over the semiconductor chips adjacent to each other comprises a step of forming the bumps from a soldered alloy material and a step of reflow soldering the respective bumps into a spherical shape after the second dicing step.

15. A method of fabricating a semiconductor device according to claim 13, wherein the step of forming the bumps spreading over the semiconductor chips adjacent to each other is a step of forming the bumps by plating.

16. A method of fabricating a semiconductor device according to claim 13, wherein at least either of the first dicing step and the second dicing step is a step of dicing by means of laser irradiation using a laser device.

17. A method of fabricating a semiconductor device according to claim 16, wherein, for the laser device, use is made of any one model or several models, selected from the group consisting of an excimer laser device, a YAG laser device, and a carbon dioxide gas laser device.

18. A structure for mounting a semiconductor device provided with a plurality of electrode pads in the vicinity of a side edge of a semiconductor chip and a plurality of bumps electrically conductive with the respective electrode pads on a circuit board, characterized in that: the plurality of the bumps are provided so as to overhang from a sidewall face of the semiconductor chip; and the sidewall face of the semiconductor chip is opposite to the circuit board; and the bumps overhanging from the sidewall face is connected with electrically conductive patterns or electrodes, provided on the circuit board, respectively.

19. A structure for mounting a semiconductor device according to claim 18, wherein the plurality of the bumps are provided so as to be extended from the upper surface of the semiconductor chip 12 with the electrode pads provided thereon onto the sidewall face.

20. A structure for mounting a semiconductor device according to claim 18, wherein the bumps are formed of a soldered alloy material, and the bumps in a melted shape are connected with electrically conductive patterns or electrodes, provided on the circuit board, respectively.

21. A structure for mounting a semiconductor device according to claim 18, wherein the bumps are connected with electrically conductive patterns or electrodes provided on the circuit board, respectively, by solder.

22. A structure for mounting a semiconductor device according to claim 18, wherein the bumps are connected with electrically conductive patterns or electrodes provided on the circuit board, respectively, by an anisotropic conductive adhesive.

23. A structure for mounting a semiconductor device provided with a plurality of electrode pads in the vicinity of side edges of a semiconductor chip and a plurality of bumps electrically conductive with the respective electrode pads on a circuit board and a flexible printed circuit board,
characterized in that: the plurality of the bumps are provided so as to overhang from two sidewall faces of the semiconductor chip, respectively; and the sidewall face on one side of the semiconductor chip is opposite to the circuit board while the sidewall face on the other side of the semiconductor chip is opposite to the flexible printed circuit board; and the bumps overhanging from the sidewall face on the one side are connected with electrically conductive patterns or electrodes, provided on the circuit board, respectively, while the bumps overhanging from the sidewall face on the other side are connected with electrically conductive patterns or electrodes provided on the flexible printed circuit, respectively.

24. A structure for mounting a semiconductor device according to claim 23, wherein the plurality of the bumps are provided so as to be extended from the upper surface of the semiconductor chip with the electrode pads provided thereon onto the two sidewall faces, respectively.

25. A structure for mounting a semiconductor device according to claim 23, wherein the two sidewall faces are sidewall faces of the semiconductor chip, parallel to each other.

26. A structure for mounting a semiconductor device according to claim 23, wherein the two sidewall faces are sidewall faces of the semiconductor chip, orthogonal to each other.

27. A structure for mounting a semiconductor device according to claim 23, wherein the bumps overhanging from the sidewall face on the one side are connected with electrically conductive patterns or electrodes provided on the circuit board, respectively, by soldering.

28. A structure for mounting a semiconductor device according to claim 23, wherein the bumps overhanging from the sidewall face on the one side are connected with electrically conductive patterns or electrodes provided on the circuit board, respectively, by an anisotropic conductive adhesive.

29. A structure for mounting a semiconductor device according to claim 23, wherein the bumps overhanging from the sidewall face on the other side are connected with electrically conductive patterns or electrodes provided on the flexible printed circuit, respectively, by soldering.

30. A structure for mounting a semiconductor device according to claim 23, wherein the bumps overhnaging from the sidewall face on the other side are connected with electrically conductive patterns or electrodes provided on the flexible printed circuit, respectively, by an anisotropic conductive adhesive.

31. A method of mounting a semiconductor device provided with a plurality of electrode pads in the vicinity of a side edge of a semiconductor chip, and a plurality of bumps electrically conductive with the respective electrode pads, formed so as to overhang from a sidewall face of the semiconductor chip, on a circuit board, said method comprising:
a step of disposing the semiconductor device such that the sidewall face of the semiconductor chip is opposite the circuit board;
a step of placing an anisotropic conductive adhesive between the bumps overhanging from the sidewall face of the semiconductor chip and the circuit board; and
a step of electrically connecting the bumps with electrically conductive patterns or electrodes provided on the circuit board, respectively, by applying heat treatment between the bumps and the circuit board while applying pressure thereto.

32. A method of mounting a semiconductor device provided with a plurality of electrode pads in the vicinity of a side edge of a semiconductor chip, and a plurality of bumps made of a soldering alloy material, electrically conductive with the respective electrode pads, formed so as to overhang from a sidewall face of the semiconductor chip, on a circuit board, said method comprising:
a step of disposing the semiconductor device such that the sidewall face of the semiconductor chip is opposite the circuit board; and
a step of melting the bumps overhanging from the sidewall face of the semiconductor chip by applying heat treatment thereto, and electrically connecting the bumps with electrically conductive patterns or electrodes, provided on the circuit board, respectively.

33. A method of mounting a semiconductor device provided with a plurality of electrode pads in the vicinity of side edges of a semiconductor chip, and a plurality of bumps electrically conductive with the respective electrode pads, formed so as to overhang from two sidewall faces of the semiconductor chip, respectively, on a circuit board and a flexible printed circuit board, said method comprising:
a step of disposing the semiconductor device such that the sidewall face on one side of the semiconductor chip is opposite the circuit board;
a step of placing an anisotropic conductive adhesive between the bumps overhanging from the sidewall face on the one side of the semiconductor chip and the circuit board;
a step of electrically connecting the bumps with electrically conductive patterns or electrodes provided on the circuit board, respectively, by applying heat treatment between the bumps and the circuit board while applying pressure thereto;
a step of disposing the semiconductor device and the flexible printed circuit board such that the sidewall face on the other side of the semiconductor chip is opposite the flexible printed circuit board;
a step of placing an anisotropic conductive adhesive between the bumps overhanging from the sidewall face on the other side of the semiconductor chip and the flexible printed circuit; and
a step of electrically connecting the bumps with electrically conductive patterns or electrodes provided on the flexible printed circuit, respectively, by applying heat treatment between the bumps and the flexible printed circuit while applying pressure thereto.
